# EUROPÄISCHE PATENTANMELDUNG

(11) **EP 2 071 046 A2**
(43) Veröffentlichungstag der Anmeldung: **17.06.2009**
(21) Anmeldenummer: 08170758.0
(22) Anmeldetag: 05.12.2008
(51) Int. Cl.: C22C 14/00, C23C 30/00, C23C 14/16, C22C 21/00

(54) **Platinbasierte Hochtemperturschutzschicht auf Aluminium-reichen Titanlegierungen und Titan-Aluminiden**

(30) Priorität: 14.12.2007 DE 102007060254
(71) Anmelder: Deutsches Zentrum für Luft- und Raumfahrt e.V., 51147 Köln (DE)
(72) Erfinder: Fröhlich, Maik, 53842 Troisdorf (DE); Ebach-Stahl, Andrea, 51147 Köln (DE)
(74) Vertreter: Jönsson, Hans-Peter

(57) **Zusammenfassung**

Die Erfindung betrifft Substrate aus Aluminium-reichen Titanlegierungen und aus Titan-Aluminiden, welche eine die Elemente Ti, Al und Pt enthaltende Beschichtung aufweisen, ein Verfahren zur Herstellung solcher beschichteten Substrate sowie ihre Verwendung. Substrate aus einer Ti-Legierung oder einem Titan-Aluminid mit einem Gehalt an Al von mindestens 15 Atom-%, welche eine die Elemente Ti, Al, und Pt enthaltende ganz- oder teilflächige Beschichtung aufweisen, haben sich bei hohen Temperaturen als besonders langzeit-oxidationsresistent erweisen.

## Beschreibung

Die Erfindung betrifft Substrate aus Aluminium-reichen Titanlegierungen und aus Titan-Aluminiden, welche eine die Elemente Ti, Al und Pt enthaltende Beschichtung aufweisen, ein Verfahren zur Herstellung solcher beschichteten Substrate sowie ihre Verwendung.

Die Entwicklung von Werkstoffen für den Einsatz bei hohen Temperaturen hat sich in den letzten Jahrzehnten vermehrt an wirtschaftlichen und ökologischen Anforderungen orientiert. Speziell im Bereich der Gasturbinen, die sowohl stationär zur Energieerzeugung als auch für den Flugbetrieb eingesetzt werden, führte der Versuch zur Verbesserung des Gesamtwirkungsgrads unter anderem zu höheren Verbrennungstemperaturen, denen die Wände der Brennkammer sowie die nachfolgende Hochdruckturbinenstufe ausgesetzt sind. Die Turbinenschaufeln, die zudem mechanisch hoch belastet werden, müssen Temperaturen von ca. 1200 bis 1300 °C standhalten. Als Schaufelmaterial in der Turbine werden heutzutage schwere Nickelsuperlegierungen verwendet. Eine Möglichkeit den Wirkungsgrad einer Gasturbine weiter zu erhöhen, besteht darin, die rotierenden Massen und somit letztlich das Gesamtgewicht zu verringern.

Als mögliche Alternativen zu den schweren Nickelsuperlegierungen bieten sich insbesondere auf Titan und Aluminium basierenden Legierungen an, da diese ein wesentlich geringeres Gewicht aufweisen. Nachteilig an diesen ist jedoch, dass sie aufgrund ihrer geringen Oxidationsbeständigkeit nicht ohne weitere Vorkehrungen eingesetzt werden können. Die Bildung schnell wachsenden Titanoxids bei hohen Temperaturen sorgt nämlich in der Regel für eine schnelle Degradierung des betreffenden Werkstoffes.

Um die Oxidationsbeständigkeit von Titan-Aluminium-Legierungen zu erhöhen, wurden bis dato verschiedene Beschichtungen entwickelt. Dabei wurde sich zum Teil an den "Bond Coats" auf Nickelsuperlegierungen orientiert.

Die folgende Tabelle zeigt einige ab dem Jahr 2000 für Titan-Aluminium-Legierungen entwickelte Schichtsysteme:

| Beschichtungswerkstoff | Beschichtungsverfahren | Jahr |
|---|---|---|
| Al₂O₃, Emaille | Magnetron-Sputtern, Emaillieren | 2000 |
| TiAl/TiAl-SiC | EB-PVD | 2000 |
| Al-Cr | Pack Cementation | 2000 |
| TiAI₃, TiAlCr | Magnetron-Sputtern | 2000 |
| Ti-48AI-2Ag | Sputtern | 2001 |
| N | Nitrierung | 2001 |
| AI-Y | EB-PVD | 2001 |
| TiAlCr | SPS (Spark Plasma Sintering) | 2002 |
| Al, NiCrAIY, CoCrAlY, TiAlCr | Pack Cementation, Magnetron-Sputtern | 2002 |
| NiCrAlY, NiCoCrAlYTa | Plasmaspritzen | 2003 |
| TiAlAg | Magnetron-Sputtern | 2003 |
| Al | Pack Cementation | 2003 |
| TiAIN/CrN, TiAIN/NbN | Arc-PVD | 2003 |
| Cr-Al | Pack Diffusion - Prozess | 2003 |
| Al | Electro-Spark Deposition | 2003 |
| Al, Si | Pack Cementation | 2003 |
| Ni-Al | Pack Cementation | 2003 |
| TiAlCrYN, TiAIYN/CrN, TiAlCr, TiAlAg | Magnetron-Sputtern | 2003 |
| Si | Silizierung | 2003 |
| TiAlCrYN, TiAIYN/CrN, TiAlCr, TiAlAg | Magnetron-Sputtern | 2003 |
| TiAlCr | Plasmaspritzen | 2004 |
| Al-Si | Arc-PVD | 2004 |
| TiAlCr, TiAlAg | Magnetron-Sputtern | 2004 |
| SiO₂ | Wärmebehandlung | 2004 |
| TiAl₂ | Magnetron-Sputtern | 2005 |
| NiAl | Galvanische Abscheidung, Pack Cementation | 2005 |
| TiAlCrYN, AI | Magnetron-Sputtern, Pack Cementation | 2005 |
| NiCrAIY, TiAlCr, Emaille | Magnetron-Sputtern, Emaillieren | 2005 |
| Si | Flüssigphasen-Silizierung | 2005 |
| AI, AINbCr | Magnetron-Sputtern | 2005 |
| TiAlCr, TiAINb, TiAlW, TiAlAg | Magnetron-Sputtern | 2005 |
| NiCrSi | Lasergestütztes Precursor-Verfahren | 2006 |
| TiAlCr, TiAlCrYN | Magnetron-Sputtern | 2006 |
| TiAlCr, TiAlCrYN | Magnetron-Sputtern | 2006 |
| TiAIW | Magnetron-Sputtern | 2007 |
| W₂C/TiC, NiCrWC | Lasergestütztes Precursor-Verfahren | 2007 |
| Al-Au, AI-Zr-Y | Magnetron-Sputtern | 2007 |
| CrAIYN/CrN | Magnetron-Sputtern | 2007 |
| Si | "Pack Siliconizing" | 2007 |
| Si, Ti-98Al, TiAlCr | Magnetron-Sputtern | 2007 |

So beschreibt EP 1 624 084 A1 beispielsweise die Beschichtung von aus Vanadium-haltigen Titanlegierungen bestehenden Substraten, um diese bei hohen Temperaturen schmieden zu können. Zu diesem Zweck werden nacheinander zwei Schichten, eine eigentliche Schutzschicht und eine darauf aufliegende glasartige Schicht, aufgebracht. Bei der Schutzschicht kann es sich um eine Aluminidbeschichtung, eine Silizium-modifizierte Aluminidbeschichtung, eine Platin-Aluminidbeschichtung, eine Aluminiumbeschichtung oder eine Platinbeschichtung handeln.

Zahlreiche Veröffentlichungen beschreiben Beschichtungen von Substraten, welche aus der IMI-834 Legierung bestehen (I. Gurrappa, "Platinum Aluminide Coatings for Oxidation Resistance of Titanium Alloys" in Platinum Metals Rev. 2001, 45, 124-129; S. P. Trivedi, D. K. Das, "Microstructural aspects of plain aluminide and Pt-aluminide coatings on Ti-base alloy IMI-834" in Intermetallics 2005, 13, 1122-1133; D. K. Das, S. P. Trivedi, "Microstructure of diffusion aluminide coatings on Ti-base alloy IMI-834 and their cyclic oxidation behaviour at 650°C" in Material Science and Engineering A, 367 (2004), 225-233; I. Gurrappa, A. K. Gogia, "High performance coatings for titanium alloys to protect against oxidation" in Surface and Coatings Technology, 139 (2001), 216-221). Für solche an Aluminium relativ armen Substrate (Zusammensetzung von IMI-834 in Gew.-%: Ti-5,8AI-4Sn-3,5Zr-0,7Nb-0,5Mo-0,35Si-0,06C) scheint das Problem mehr oder weniger zufriedenstellend gelöst zu sein: Nach der Erzeugung einer Ti, AI und Pt enthaltenden Schutzschicht auf dem IMI-834-Substrat bildet sich unter Einsatz von höheren Temperaturen auf der besagten Schutzschicht eine weitere Al₂O₃-Schicht, auf welche wiederum die eigentliche Oxidationsstabilität zurückzuführen ist.

Demgegenüber scheinen Aluminium-reichere Titanlegierungen nur in wesentlich geringerem Umfang Gegenstand entsprechender Forschungsanstrengungen gewesen zu sein. In diesem Zusammenhang beschreibt US 5,879,760 A ein Verfahren zum Schutz von Titan-Aluminid-Substraten durch das Aufbringen zweier Schichten, einer ersten Schicht aus einer duktilen Titanlegierung und einer zweiten Oxidations-resistenten und auf der ersten Schicht aufliegenden Schicht bestehend aus einem Edelmetall und gegebenenfalls Wolfram. In diesem Zusammenhang werden jedoch keine Angaben über die Oxidationsbeständigkeit entsprechend beschichteter Substrate gemacht.

Trotz der Vielfalt der oben beschriebenen bzw. angerissenen Verfahren zur Beschichtung von Aluminium-haltigen Titanlegierungen mangelt es gegenwärtig immer noch an entsprechend wirksamen Beschichtungen für Aluminium-reiche Titanlegierungen und Titan-Aluminide, welche insbesondere in Anbetracht der Tatsache von technischer Bedeutung sind, dass diese im Vergleich zu beispielsweise IMI-834 eine geringere Dichte sowie eine bessere Strukturstabilität bei höheren Temperaturen aufweisen.

Oft konnte zwar in den jeweiligen Untersuchungen erfolgreich die Massenzunahme reduziert werden, doch beschränkte sich dies weitestgehend auf Zeiträume von 10 bis 100 Stunden. Unberücksichtigt blieben jeweils Effekte, die bei anwendungsrelevanten Zeiten oberhalb von 100 oder sogar 1000 Stunden auftreten: Interdiffusionsprozesse zwischen Substrat und Schicht haben die Abreicherung von Deckschicht-bildenden Elementen zur Folge, was im schlimmsten Fall zum Ausfall des Schichtsystems führt. Bedingt durch die Diffusionsvorgänge können ebenso Kirkendall-Poren entstehen, die einen weiteren Diffusionspfad für den Sauerstoff darstellen sowie die mechanische Stabilität des Schichtsystems gefährden. Ferner führen diffusionsbedingte Phasenumwandlungen im Substrat zu Beeinträchtigungen der mechanischen Eigenschaften des Grundwerkstoffs.

Aufgabe der vorliegenden Erfindung ist es daher, Beschichtungen für Substrate aus Aluminium-reichen Titanlegierungen und Titan-Aluminiden zur Verfügung zu stellen, die den Substraten auch bei einer Langzeitanwendung unter hohen Temperaturen eine hohe Oxidationsresistenz verleihen.

Gelöst wurde die der vorliegenden Erfindung zugrundeliegende Aufgabe in einer ersten Ausführungsform durch ein Substrat aus einer Ti-Legierung mit einem Gehalt an Al von mindestens 15 Atom-%, welches eine ganz- oder teilflächige die Elemente Ti, AI und Pt enthaltende Beschichtung aufweist.

Bevorzugt sind die Elemente Ti, AI und Pt dabei gleichmäßig, d.h. homogen, innerhalb der Beschichtung verteilt. Eine homogene Verteilung dieser drei Bestandteile innerhalb der Beschichtung folgt auch schon aus den weiter unten noch eingehender zu erörternden Verfahren zum Aufbringen einer solchen Beschichtung im Magnetron-Sputterverfahren unter Einsatz eines AI- und eines Pt-Targets, da sich im Zuge dessen Ti aus dem Substrat heraus automatisch innerhalb der Beschichtung homogen verteilt.

Weiterhin ist es bevorzugt, dass die Ti-, Al und Pt-enthaltende Beschichtung auf dem Substrat aufliegt bzw. an dieses angrenzt, so wie es beispielsweise bei beschichteten Substraten der Fall ist, die nach dem Magnetron-Sputterverfahren hergestellt werden.

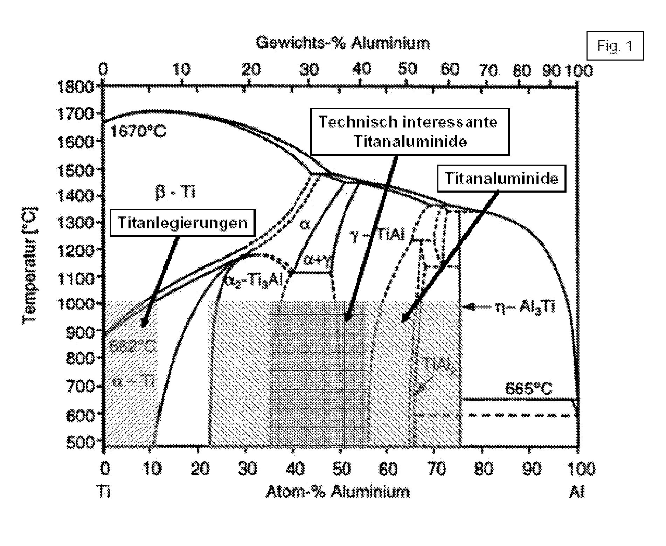

Bevorzugt liegt der Gehalt von AI in der Ti-Legierung in einem Bereich von 22 bis 76, besonders bevorzugt in einem Bereich von 36 bis 55 Atom-%. Titanlegierungen mit einem Gehalt an Aluminium innerhalb dieser Grenzen werden gemeinhin auch als Titan-Aluminide bezeichnet. Die oben angegebenen bevorzugten Bereiche sind in Fig. 1 durch einfache bzw. doppelte Schraffur kenntlich gemacht. Davon abzugrenzen sind Titan-Aluminium-Zusammensetzungen, deren Gehalt an Aluminium geringer bzw. höher ist; erstere werden in der Regel unter dem Begriff der "einfachen" Titanlegierungen zusammengefasst (beispielsweise der in Fig. 1 auf der linken Seite liegende schraffierte Bereich, welcher im Wesentlichen α-Ti umfasst und einen Gehalt an Aluminium in Atom-% von 0 bis ca. 11 % (bei Temperaturen < 550 °C) aufweist).

Die auf dem Substrat befindliche Beschichtung weist bevorzugt einen Gehalt an Ti in einem Bereich von 10 bis 55, insbesondere von 13 bis 50 Atom-% auf.

Des Weiteren ist sie dadurch gekennzeichnet, dass der Gehalt an AI bevorzugt in einem Bereich von 25 bis 60, insbesondere von 35 bis 57 Atom-% liegt.

Der Gehalt von Pt in der Beschichtung liegt bevorzugt in einem Bereich von 10 bis 35 Atom-%.

Ganz besonders bevorzugt liegen die Gehalte der Elemente Ti, Al und Pt in der Beschichtung in Atom-% in einem Bereich, der in einem ternären Phasendiagramm (Ti, Al, Pt) durch die von den folgenden Punkten aufgespannte Fläche gegeben ist: (50, 35, 15), (50, 40, 10), (13, 52, 35) und (13, 57, 30). Die Fläche ergibt sich dabei im ternären Phasendiagramm aus der Verbindung der Punkte untereinander, wobei ein Punkt jeweils nur mit den zwei ihm am nächsten liegenden Punkten verbunden wird.

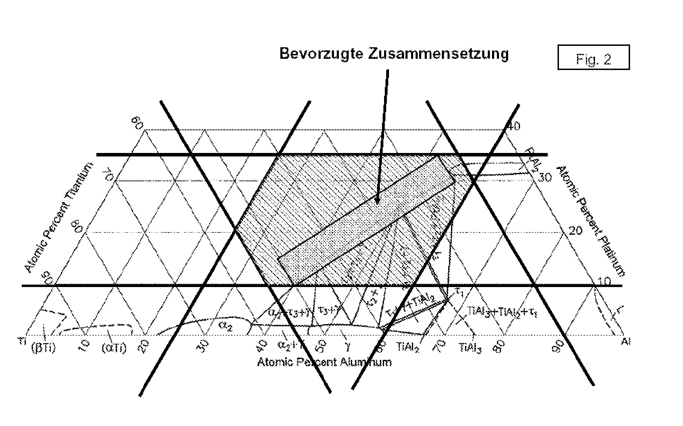

Anschaulich sind die soeben beschriebenen bevorzugten Bereiche noch einmal in Fig. 2 dargestellt, welche einen Ausschnitt aus einem ternären Phasendiagramm darstellt. Bevorzugte Zusammensetzungen liegen dabei innerhalb des einfach schraffierten Sechsecks, ganz besonders bevorzugte Zusammensetzungen innerhalb des doppelt schraffierten Rechtecks.

Die oben angegebenen Bereiche der Beschichtungsbestandteile Ti, AI und Pt sind dabei insofern besonders bevorzugt, als nur innerhalb dieser Bereiche eine hohe Langzeit-Oxidationsresistenz der beschichteten Substrate beobachtet wird. Insbesondere überraschend ist in diesem Zusammenhang das Auffinden eines sehr engen Zusammensetzungsbereiches (vgl. Rechteck im ternären Phasendiagramm), innerhalb dessen die Oxidationsresistenz besonders ausgeprägt ist.

Selbst wenn die Zusammensetzung der Beschichtungen anhand eines ternären Phasendiagramms erläutert wurde, bedeutet dies jedoch nicht, dass die besagte Beschichtung nur die Elemente Ti, AI bzw. Pt enthalten kann. Darüber hinaus können ebenfalls andere Elemente vertreten sein. Bevorzugt ist es beispielsweise möglich, dass die Beschichtung darüber hinaus Niob in einem Bereich von 0 bis 15, insbesondere von 2 bis 10 Atom-% enthält.

Oft lässt sich die Anwesenheit anderer Elemente in der Beschichtung auch schon deshalb nicht vermeiden, als auch Substrate beschichtet werden können, die nicht nur die Elemente Ti und AI enthalten. Ein bevorzugtes Substrat ist in diesem Zusammenhang die Titan-Aluminid-Legierung Ti-45Al-8Nb (Angabe in Atom-%), welche (ohne zusätzliches Auftragen von Nb) zu einer zum Teil Nb-haltigen Beschichtung führt. Eine Diffusion einzelner Substratbestandteile in die aufzubringende Beschichtung während des Beschichtungsverfahrens lässt sich oft gar nicht vermeiden, steht der Stabilität der Beschichtung und insbesondere der Langzeit-Oxidationsresistenz aber nicht nachteilig im Wege (so unterscheidet sich die Stabilität einer Nb-enthaltenden Beschichtung auf Ti-45AI-8Nb nicht von einer solchen, die auf binärem Titan-Aluminid aufgebracht wurde).

Die Schichtdicke der die Elemente Ti, AI und Pt enthaltenen Beschichtung liegt vorzugsweise in einem Bereich von 1 bis 50 µm.

Bei einer Schichtdicke unterhalb von 1 µm weisen die beschichteten Substrate nur eine unzureichende Langzeit-Oxidationsresistenz auf. Eine Schichtdicke oberhalb von 50 µm ist insofern benachteiligt, als die Langzeit-Oxidationsresistenz nicht weiter zunimmt, aber zusätzliche Kosten durch die größeren Mengen an aufgebrachtem Pt entstehen.

Substrate, die die oben beschriebenen Anforderungen hinsichtlich ihres Aluminiumgehaltes erfüllen, und welche darüber hinaus eine durch die obigen Gehaltsangaben und Schichtdicken genauer spezifizierte Beschichtung aufweisen, haben sich als besonders Oxidations-resistent erwiesen. Nach Belastungsuntersuchungen obiger Substrate bei erhöhter Temperatur hat sich gezeigt, dass sich auf besagter Beschichtung eine geschlossene, langsam wachsende Al₂O₃-Oberflächenschicht bildet, auf welche die eigentliche Oxidationsresistente Wirkung zurückzuführen ist.

Durch die Gehalte der einzelnen Elemente im Substrat bzw. in der darauf aufliegenden Beschichtung ist der sich unter den Benutzungsbedingungen ausbildende Dreischichtaufbau aus Substrat, Ti-AI-Pt-Schicht und Al₂O₃-Schicht besonders langzeitresistent. Als Grundlage dafür angesehen werden kann ein sich zwischen verschiedenen Diffusionsprozessen einstellendes Gleichgewicht, wodurch Porenbildungen und/oder Phasenumwandlungen sowohl im Substrat als auch in der darauf aufliegenden Beschichtung vermieden werden. Da sich auf der Ti-AI-Pt-Beschichtung eine Al₂O₃-Oberflächenschicht ausbildet, kommt den AI-Gehalten im Substrat und in der Beschichtung eine besondere Bedeutung zu. Erfindungsgemäß hat sich gezeigt, dass der Unterschied zwischen den AI-Gehalten im Substrat bzw. der Beschichtung von besonderer Bedeutung ist. Dieser Unterschied, oder auch Gradient, sollte möglichst gering sein.

Da die eigentliche Schutzwirkung auf der Ausbildung der Al₂O₃-Oberflächenschicht beruht, muss die Ti-AI-Pt-Beschichtung notwendigerweise einen ausreichenden AI-Gehalt aufweisen. Das darin zur Ausbildung der Al₂O₃-Oberflächenschicht aufgewendete Al wird vom Substrat durch Diffusion in die Ti-AI-Pt-Beschichtung nachgeliefert. Offenbar wirkt sich ein geringer Gradient gerade innerhalb dieses Nachlieferungs-Diffusionsprozesses als besonders vorteilhaft aus.

In einer zweiten Ausführungsform wird die der Erfindung zugrundeliegende Aufgabe gelöst durch ein Verfahren zur Herstellung eines beschichteten Substrats wie zuvor beschrieben, wobei man das Substrat aus der Ti-Legierung oder dem Titan-Aluminid durch den Einsatz eines AI- und eines Pt-Targets im Magnetronsputter-Verfahren beschichtet. Ein Ti-Target braucht hier nicht verwendet zu werden, da sich der oben beschriebene Ti-Gehalt in der Beschichtung automatisch zu Beginn der Hochtemperaturauslagerung durch Diffusionsprozesse aus dem Substrat in die Beschichtung hinein einstellt. Durch im Rahmen des Magnetronsputter-Verfahrens übliche Variationen lassen sich unter Verwendung der gleichen Targets ebenfalls unterschiedliche Beschichtungszusammensetzungen wie z.B. Pt, PtAI und PtAl₂ erzielen.

In einer dritten Ausführungsform wird die der Erfindung zugrundeliegende Aufgabe gelöst durch die Verwendung eines Substrats wie oben beschrieben im Turbinenbau, insbesondere als Turbinenschaufel oder im Automobilbau. Gemeinhin bieten sich insbesondere solche Anwendungsfelder an, bei denen die Substrate über längere Zeiträume hinweg hohen Temperaturen ausgesetzt sind.

### Ausführungsbeispiel:

In einem Magnetronsputter-Verfahren wurde eine 10 µm dicke Pt-52AI-Schicht (Angabe in Atom-%) auf einer Ti-45AI-8Nb-Legierung mittels Magnetronsputter-Verfahren aufgebracht. Hierzu wurden eine Quelle mit einem Aluminium-Target und eine Quelle mit einem Platin-Target verwendet.

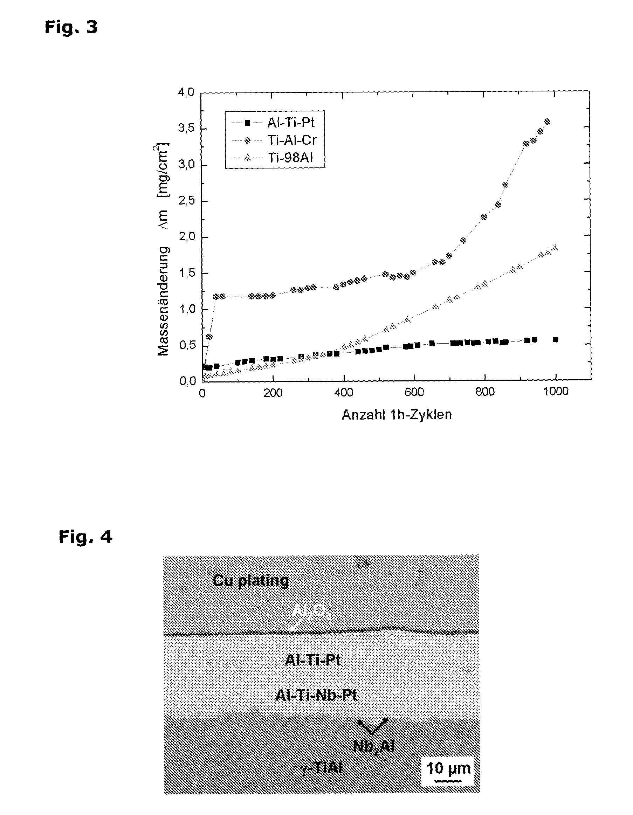

Zyklische Auslagerungstests bei 950 °C für 1000 1h-Zyklen an der Luft (1 Zyklus: 1h heizen, 10 min kühlen) zeigten eine sehr geringe Massenzunahme (Fig. 3) im Vergleich zu anderen Schichten und eine intakte Aluminiumoxid-Deckschicht mit einer darunter liegenden stabilen AI-Ti-Pt-Schicht, die zum Teil mit Niob angereichert war (Fig. 4).

Fig. 3 zeigt einen Vergleich der Oxidationskinetiken von Ti-98AI-, Ti-AI-Cr und Ti-AI-Pt-Schichten bei 950 °C an Luft.

Fig. 4 zeigt eine Rasterelektronen-mikroskopische Aufnahme einer Ti-AI-Pt-Schicht nach einer Auslagerung von 1000 1h-Zyklen bei 950 °C an Luft.

Derartig gute Ergebnisse wurden bisher für kein anderes Schichtsystem auf Ti- und TiAI-basierten Werkstoffen beobachtet.

## Patentansprüche

1. Substrat aus einer Ti-Legierung mit einem Gehalt an AI von mindestens 15 Atom-%, **dadurch gekennzeichnet, dass** es eine ganz- oder teilflächige auf dem Substrat aufliegende Beschichtung aufweist, die die Elemente Ti, AI und Pt enthält.

2. Substrat nach Anspruch 1, **dadurch gekennzeichnet, dass** die Ti-Legierung ein Titan-Aluminid mit einem Gehalt an Al in einem Bereich von 22 bis 76, insbesondere von 36 bis 55 Atom-% ist.

3. Substrat nach einem der Ansprüche 1 oder 2, **dadurch gekennzeichnet, dass** die Beschichtung Ti in einem Bereich von 10 bis 55, insbesondere von 13 bis 50 Atom-% enthält.

4. Substrat nach einem der Ansprüche 1 bis 3, **dadurch gekennzeichnet, dass** die Beschichtung AI in einem Bereich von 25 bis 60, insbesondere von 35 bis 57 Atom-% enthält.

5. Substrat nach einem der Ansprüche 1 bis 4, **dadurch gekennzeichnet, dass** die Beschichtung Pt in einem Bereich von 10 bis 35 Atom-% enthält.

6. Substrat nach einem der Ansprüche 1 bis 5, **dadurch gekennzeichnet, dass** die Gehalte der Elemente Ti, Al und Pt in der Beschichtung in Atom-% in einem Bereich liegen, der in einem ternären Phasendiagramm (Ti,AI,Pt) durch die von den folgenden Punkten aufgespannte Fläche gegeben ist: (50,35,15), (50,40,10), (13,52,35) und (13,57,30).

7. Substrat nach einem der Ansprüche 1 bis 6 **dadurch gekennzeichnet, dass** die Beschichtung Nb in einem Bereich von 0 bis 15, insbesondere von 2 bis 10 Atom-% enthält.

8. Substrat nach einem der Ansprüche 1 bis 7, **dadurch gekennzeichnet, dass** die Beschichtung eine Schichtdicke in einem Bereich von 1 bis 50 µm aufweist.

9. Substrat nach einem der Ansprüche 1 bis 8 **dadurch gekennzeichnet, dass** die Ti-AI-Pt-haltige Beschichtung eine ganz- oder teilflächig darauf befindliche Oberflächenschicht aus Al₂O₃ aufweist.

10. Substrat nach einem der Ansprüche 1 bis 9, **dadurch gekennzeichnet, dass** die Ti-AI-Pt-haltige Beschichtung die Elemente Ti, Al und Pt jeweils gleichmäßig innerhalb der Beschichtung verteilt enthält.

11. Verfahren zur Herstellung eines Substrats nach einem der Ansprüche 1 bis 10, **dadurch gekennzeichnet, dass** man das Substrat aus der Ti-Legierung durch den Einsatz eines AI- und eines Pt-Targets im Magnetronsputter-verfahren beschichtet.

12. Verwendung eines Substrats nach einem der Ansprüche 1 bis 10 im Turbinenbau, insbesondere als Turbinenschaufel, oder im Automobilbau.
